(19) Europäisches Patentamt / European Patent Office / Office européen des brevets

(11) **EP 4 707 818 A2**

(12) **EUROPÄISCHE PATENTANMELDUNG**

(43) Veröffentlichungstag:
**11.03.2026   Patentblatt 2026/11**

(21) Anmeldenummer: **25191190.5**

(22) Anmeldetag: **23.07.2025**

(51) Internationale Patentklassifikation (IPC):
**G01R 1/067** *(2006.01)*      **G01R 19/00** *(2006.01)*

(52) Gemeinsame Patentklassifikation (CPC):
**G01R 1/06788; G01R 19/0046; G01R 19/0084**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH LA MA MD TN**

(30) Priorität: **16.08.2024   DE 102024123451**

(71) Anmelder: **DEHN SE**
**92318 Neumarkt i.d. OPf. (DE)**

(72) Erfinder:
• **Kienlein, Reinhold**
  **92318 Neumarkt i.d.OPf. (DE)**
• **Meier, Wolfgang**
  **92318 Neumarkt i.d.OPf (DE)**
• **Maget, Johannes**
  **92318 Neumarkt i.d.OPf. (DE)**
• **Mayer, Lena**
  **92318 Neumarkt i.d.OPf. (DE)**

(74) Vertreter: **Keller Schneider**
**Patentanwaltsgesellschaft mbH**
**Lessingstraße 11**
**80336 München (DE)**

(54) **SPANNUNGSMESSEINRICHTUNG ZUM PRÜFEN EINER SPANNUNG AN EINEM ELEKTRISCHEN LEITER UND VERFAHREN ZUM PRÜFEN EINER SPANNUNG AN EINEM ELEKTRISCHEN LEITER MIT EINER SPANNUNGSMESSEINRICHTUNG**

(57)    Die Erfindung betrifft eine Spannungsmesseinrichtung (1) zum Prüfen einer Spannung an einem elektrischen Leiter (EL), umfassend eine Spannungsmesseinheit (3), einen Lage- /Beschleunigungssensor (2), eine Steuerungseinrichtung (SE), mit welcher der Antastvorgang mit einem vorbestimmten und in der Steuerungseinrichtung (SE) hinterlegten Beschleunigungsmuster (und in Kombination mit der elektrischen Impulserkennung, welche zeitgleich erfolgt und logisch mit "und" verknüpft ist) für ein erfolgreiches Antasten vergleichbar ist und ein erfolgreiches Antasten erkennbar und/oder ausschließbar ist und im Falle eines erfolgreichen Antastens zumindest eine Information über eine von der Spannungsmesseinheit (3) ermittelten Spannung in dem elektrischen Leiter (EL) erzeugbar ist; eine Speichereinrichtung (SP), in welcher vorbestimmte Daten über ein Beschleunigungsmuster der Spannungsmesseinheit (3) hinterlegbar sind oder hinterlegt sind; und eine Kommunikationsschnittstelle (4), wobei mit der Kommunikationsschnittstelle (4) die zumindest eine Information über eine von der Spannungsmesseinheit (3) ermittelten Spannung (und die Information über ein erfolgreiches elektrisches Antasten) in dem elektrischen Leiter (EL) an einen externen Empfänger (E) über eine Drahtlosverbindung übermittelbar ist, wobei in einem automatisierten Vorgang bei einem erfolgreichen Antasten und einer erkannten Spannung im elektrischen Leiter (EL) die zumindest eine Information über die ermittelte Spannung über die Kommunikationsschnittstelle (4) übertragbar ist und Zeit- und/oder Positionsinformationen über die erkannte Spannung erzeugbar und in der Speichereinrichtung (SP) ablegbar und/oder über die Kommunikationsschnittstelle (4) übertragbar sind.. Die Spannungsmesseinrichtung (1) kann zusätzlich zum beschriebenen Antastvorgang oder anstatt diesem eine Funktion einer Frequenzerkennung aufweisen und durchführen, wobei eine automatische und frequenzabhängige Detektionsschwelleneinstellung erfolgen kann und je nach Einstellung eine Meldung bei Frequenzabweichung.

Fig. 1

**Beschreibung**

Die vorliegende Erfindung betrifft eine Spannungsmesseinrichtung zum Prüfen einer Spannung an einem elektrischen Leiter und ein Verfahren zum Prüfen einer Spannung an einem elektrischen Leiter mit einer Spannungsmesseinrichtung.

In der Messtechnik werden technische Mittel zur Prüfung von Messmitteln, also beispielsweise Messgeräten oder Messeinrichtungen, als Prüfmittel bezeichnet. Im Rahmen der fünf Sicherheitsregeln kann ein Spannungsprüfer zur Ermittlung einer Spannung oder einer Restspannung in einer Anlage zu Einsatz kommen, wobei je nach Anlage zwischen unterschiedlichen Prüfern unterschieden werden kann.

In der DE 10 2012 110 623 B4 wird ein Messgerät zum Durchführen von Mess- und Prüfaufgaben in vorgebbaren Prozessen beschrieben. Es kann eine Programmablauf-Routine gestartet und nacheinander die Prozessschritte aufgerufen werden und eine Aufgabe eines jeweils aufgerufenen Prozessschrittes auf einem Display graphisch darzustellen.

Vor diesem Hintergrund liegt der vorliegenden Erfindung die Aufgabe zugrunde, eine Spannungsmesseinrichtung zum Prüfen einer Spannung an einem elektrischen Leiter und ein Verfahren zum Prüfen einer Spannung an einem elektrischen Leiter mit einer Spannungsmesseinrichtung anzugeben, wobei ein Antasten an einen elektrischen Leiter und eine Spannungsprüfung in diesem verbessert und automatisiert werden können und das Ergebnis an einer Applikationssoftware dargestellt werden kann.

Mit der Spannungsmesseinrichtung kann vorteilhaft eine drahtlose Verbindung zu einem externen Empfänger, beispielsweise einem Smartphone, aufgebaut werden, wobei ein Prüfen des vorliegenden Spannungszustands beim Antasten an das Anlageteil erkannt werden kann und das Ergebnis an einen externen Empfänger, beispielsweise ein Smartphone, übertragen werden kann, ohne dass der Anwender selbst eine zusätzliche Aktivität (etwa Drücken eines Tasters) durchführen muss. Dazu kann beispielsweise im Rahmen der fünf Sicherheitsregeln, das Prüfen der Spannung zu dokumentiert werden (Datum-, Zeit- und Ortsdaten), um nachträglich nachvollziehen zu können, ob der Anwender das Gerät auch verwendet hat. Darüber hinaus kann nach der Rückmeldung "Spannungsfreiheit festgestellt" eine elektronische Freigabe zum nächsten Arbeitsschritt "Erden und Kurzschließen" erfolgen.

Erfindungsgemäß wird diese Aufgabe gelöst durch eine Spannungsmesseinrichtung zum Prüfen einer Spannung an einem elektrischen Leiter gemäß den Merkmalen des Anspruchs 1 oder 10 und durch ein Verfahren zum Prüfen einer Spannung an einem elektrischen Leiter mit einer Spannungsmesseinrichtung gemäß den Merkmalen des Anspruchs 13 oder 25.

Erfindungsgemäß umfasst die Spannungsmesseinrichtung zum Prüfen einer Spannung an einem elektrischen Leiter eine Spannungsmesseinheit, mit welcher ein Vorhandensein und/oder eine Abwesenheit der Spannung in dem elektrischen Leiter erkennbar ist; einen Lage-/Beschleunigungssensor, mit welchem ein Beschleunigungsmuster eines Antastvorgangs der Spannungsmesseinheit an den elektrischen Leiter erkennbar ist; eine Steuerungseinrichtung, welche in der Spannungsmesseinheit umfasst oder mit dieser verbunden ist und mit welcher der Antastvorgang mit einem vorbestimmten und in der Steuerungseinrichtung hinterlegten Beschleunigungsmuster und in Kombination mit einer elektrischen Impulserkennung, welche zeitgleich erfolgen kann (und logisch mit "und" verknüpft sein kann) für ein erfolgreiches Antasten vergleichbar ist und ein erfolgreiches Antasten erkennbar und/oder ausschließbar ist und im Falle eines erfolgreichen Antastens zumindest eine Information über eine von der Spannungsmesseinheit ermittelten Spannung in dem elektrischen Leiter erzeugbar ist; eine Speichereinrichtung, welche in der Steuerungseinrichtung umfasst oder mit der Steuereinrichtung verbindbar ist und in welcher vorbestimmte Daten über ein Beschleunigungsmuster der Spannungsmesseinheit hinterlegbar sind oder hinterlegt sind; und eine Kommunikationsschnittstelle, welche mit der Steuerungseinrichtung zur Datenübertragung verbunden ist und wobei mit der Kommunikationsschnittstelle die zumindest eine Information über eine von der Spannungsmesseinheit ermittelten Spannung in dem elektrischen Leiter und über ein erfolgreiches Antasten an einen externen Empfänger über eine Drahtlosverbindung übermittelbar ist, wobei in einem automatisierten Vorgang bei einem erfolgreichen Antasten und einer erkannten Spannung im elektrischen Leiter die zumindest eine Information über die ermittelte Spannung über die Kommunikationsschnittstelle übertragbar ist und Zeit- und/oder Positionsinformationen über die erkannte Spannung erzeugbar und in der Speichereinrichtung ablegbar und/oder über die Kommunikationsschnittstelle übertragbar sind.

Als Antasten kann sowohl das erfolgreiche mechanische Antasten als auch die gleichzeitig erfolgreich durchgeführte elektrische Impulserkennung verstanden werden. Es kann sich dabei im Falle der Impulserkennung auch nur um die Tatsache der Durchführung der Impulserkennung (Ermitteln der Spannung) handeln, wobei diese Spannung dann als vorliegend erkannt werden kann aber nicht vorliegen braucht.

Die Spannungsmesseinrichtung kann einen smarten Prüfer darstellen, welcher an eine Applikationssoftware eines externen Empfängers Daten schicken kann, beispielsweise Warnungen, Informationen über ein Antasten und dessen Erfolg, über eine ermittelte Spannung oder die Abwesenheit der Spannung, über einen zeitlichen Verlauf von Parametern sowie weiteres, und Informationen und Anweisungen von der Applikationssoftware empfangen und umsetzen kann. Das Erkennen eines Vorhandenseins oder Nichtvorhandenseins der Spannung in einer unter Spannung stehenden Anlage oder einer Restspannung in einer freigeschalteten Anlage kann derart erfolgen, dass die gemessene Spannung/Restspannung im Falle des Vorhandenseins einen jeweiligen Schwellenwert überschreitet und dadurch als "vorhanden" erkannt werden kann. Bei Unterschreiten dieser Schwelle kann festgelegt sein, dass etwaige Spannungen als zu gering angenommen werden, um als Spannung/Restspannung erkannt zu werden, was als Nichtvorhandensein geartet werden kann.

Die Spannungsmesseinrichtung kann vorteilhaft das Antasten und die Spannungsmessung automatisch durchführen und an den externen Empfänger, beispielsweise an ein Mobiltelefon, und an dessen Applikationssoftware dokumentieren. Auf diese Weise kann die Spannungsmesseinrichtung erkennen und dokumentieren, sobald diese benutzt wird, um Leitungen auf Spannung zu überprüfen, was bei spannungsführenden aber auch bei freigeschalteten Anlagen erfolgen kann.

Zu diesem Zweck sind der Lage-/Beschleunigungssensor in der Spannungsmesseinrichtung umfasst und zur Messung der Spannung kann in der Steuereinrichtung eine elektrische Impulserkennung implementiert sein.

Durch den Beschleunigungssensor kann beim Antasten ein Stoß nach vorne zur Leitung und die Bewegung zurück zu detektiert werden.

Bei der Spannungsmessung kann im Rahmen der elektrischen Impulserkennung bei freigeschalteten Anlagen beim Antasten eine Restspannung detektiert werden. Restspannungen können bei noch nicht kurzgeschlossenen Leitungen und bei sehr langen Leitungen durch Einkopplungen aus anderen Leitungen auftreten.

Bei Anlagen unter Spannung kann die Spannungsdetektion des Prüfers die Spannung der Anlage erkennen. Wenn beim Antasten der Beschleunigungssensor auslöst und die Impulserkennung Spannung bzw. den Verschiebestrom erkennt, kann ein erfolgreiches Antasten mit vorhandener Spannung/Restspannung, und an entsprechendem Datum, Uhrzeit und Ort dokumentiert werden.

Der elektrische Leiter kann eine Leitung im Außenbereich oder Innenbereich und/oder in einer Wand sein. Die darin geführte Spannung kann einer Hochspannung oder einer Niederspannung entsprechen. Die Spannungsmesseinrichtung kann ein Gehäuse und eine Halterung umfassen, und alle genannten Komponenten in dem Gehäuse angeordnet oder mit diesem verbunden sein. Eine Abwesenheit der Spannung kann einem Nichtvorhandensein entsprechen, wobei das Vorhandensein und das Nichtvorhandensein sich an einer Detektionsschwelle orientieren können, wobei angenommen werden kann, dass unterhalb der Detektionsschwelle zwar auch noch Spannung/Restspannung vorhanden sein kann, diese aber als nicht mehr nennenswert im Sinne der Analyse betrachtet wird. Es kann für das Messen der Spannung bei angeschlossenen Anlagen und einer Restspannung bei freigeschalteten Anlagen mit unterschiedlichen und jeweils anwendbaren Detektionsschwellen verglichen werden. Der Sensor kann ein Lagesensor und ein Beschleunigungssensor sein oder nur ein Beschleunigungssensor sein. Der Antastvorgang kann einer Annäherung an den elektrischen Leiter entsprechen, insbesondere derart, dass die Spannung in diesem gemessen werden kann, also die Spannungsmesseinheit (Kontakte) ausreichend nah an dem elektrischen Leiter oder mit diesem in mechanischen Kontakt sein. Die Information über die Spannung kann eben deren Vorhandensein oder Nichtvorhandensein betreffen, hinsichtlich der Detektionsschwelle zur Spannung oder Restspannung. Das Beschleunigungsmuster kann den Verlauf der Beschleunigung der Spannungsmesseinrichtung betreffen, beispielsweise einen erkennbaren Annäherungsverlauf (gemessene Beschleunigung über einen Annäherungsvorgang) und ein starkes Abstoppen beim Anstoßen an den Leiter. Dieses Profil kann im Gradienten der Beschleunigung einem bekannten Muster entsprechen, für welches es bekannt ist, dass die Spannungsmesseinrichtung an ein hartes Material angestoßen ist. Dies kann insbesondere anhand von Komponenten der Beschleunigung in zumindest einer bestimmten Raumrichtung nachvollzogen werden, etwa in Längsrichtung zum Leiter hin und/oder wenn sich alle Raumkomponenten derart verändern, dass sich eine Hinbewegung mit abrupter Abstoppbewegung an einer vorderen Seite erkennen lässt (zum Leiter hin). Dies kann beispielsweise von einem Abstellen auf einem Boden unterschieden werden, was einer Bewegung in eine andere Richtung entspricht und nicht alle Raumrichtungen betrifft (Bodenkomponenten nicht oder nicht ausreichen verändert). Der externe Empfänger kann ein Mobiltelefon, eine Cloud oder ein Computer sein, und es kann drahtlos über WLAN, Bluetooth oder Funkverbindung kommuniziert werden.

Gemäß einer bevorzugten Ausführungsform der Spannungsmesseinrichtung ist die Steuerungseinrichtung dazu eingerichtet, gemäß dem hinterlegten Beschleunigungsmuster oder zumindest eines weiteren Beschleunigungsmusters über den Beschleunigungssensor einen Stoß in Richtung zum elektrischen Leiter hin und eine Bewegung vom elektrischen Leiter weg und/oder ein Absetzen der Spannungsmesseinheit auf einer Unterlage zu erkennen.

Vorteilhaft kann auch ein schiefes Absetzten oder ein Absetzen unter einem bestimmten Winkel erkannt werden.

Gemäß einer bevorzugten Ausführungsform der Spannungsmesseinrichtung umfasst die Speichereinrichtung einen Flash-Speicher und/oder ein EEPROM.

Das EEPROM kann ein externer Speicherbaustein am Spannungsprüfer sein, der über Bluetooth Kommandos konfiguriert werden kann. Es kann eine bestimmte Anzahl von möglichen Abtastwerten oder Größe von Intervallen (vorbestimmte Größen), beispielsweise auch ein Zeitintervall für eine Ermittlung einer Überschreitung eines Grenzwerts der Beschleunigung beim mechanischen Antasten im EEPROM hinterlegt sein. Des Weiteren können auch weitere Konstanten hinterlegt sein sowie Intervalle für erlaubte Vielfache davon, die dann als jeweilige anzuwendende (oder erlaubte) Detektionsschwellen, Abtastintervalle/werte, Zeitschaltwerte für Sensoren (oder zum Abtasten), Berechnungswerte für Bodenwerte dienen können.

Zur Erkennung einer mechanischen Antastung kann ein Click-Time Limit gesetzt werden, welches als Wert beispielsweise ein Vielfaches eines vordefinierten Abtastintervalls annehmen kann, etwa 00 - 99 * Abtastwert (vorbestimmter Wert oder digit).

Eine Abtastrate kann auf 1,344kHz vordefiniert sein, was einem Abtastintervall von 0,744 ms entsprechen kann.

Dies kann jener Zeit entsprechen, in welcher ein mechanischer Impuls beim Antasten nach vorne (zum Leiter hin) beendet werden sollte. Dabei soll eine Änderung der Beschleunigung in der Messzeit den vorbestimmten Grenzwert für das Auslösen des Interrupts überqueren und nachträglich wieder unterwandern.

Beispielsweise können drei verschiedene Abtast(grund)werte (Vorgabekonstanten/Abtastraten) genutzt werden/hinterlegt sein. Damit kann vorteilhaft ein Antasten beispielsweise an einer Kupferschiene von einem weichen Material unterschieden werden.

Für das Antasten kann der Grenzwert beispielsweise eine Spanne von 0 - 127 digit abdecken. Beispielsweise kann für ein Fullscale von +-4g (vierfache Erdbeschleunigung) bei einer Skalierung von 50 der Grenzwert einem 1,57 g entsprechen.

Der Beschleunigungssensor kann auf einen Messbereich von +-4g eingestellt werden. Dieser Messbereich kann mit 12bit aufgelöst sein. Mit anderen Worten kann der digitale Wert +-2047 den +-4g entsprechen (1023 entspricht 2g,... ). Der Beschleunigungssensor kann in einem Interruptmodus betrieben werden. Das heißt: Sobald ein bestimmtes Ereignis eintritt, kann dies an den Hauptcontroller gemeldet werden. Dieses Ereignis kann beim Beschleunigungssensor das Überschreiten eines Beschleunigungwertes in Kombination mit dem Click Time Limit sein. Der Beschleunigungsgrenzwert kann in 127 Werten aufgelöst werden, und 4g entsprechen beispielsweise 127 digit. 1,57g entsprechen 50 digit. "0 - 127 digit.

Gemäß einer bevorzugten Ausführungsform der Spannungsmesseinrichtung umfasst das hinterlegte Beschleunigungsmuster eine Vorgabe über eine Beschleunigung, die einem erwarteten Beschleunigungsprofil zum Anstoßen der Spannungsmesseinheit am elektrischen Leiter entspricht; und/oder eine Beschleunigungsruhephase während eines Messvorgangs umfasst und/oder eine dem Messvorgang nachfolgende Beschleunigungsphase umfasst, welche in Sequenz einer Verifizierung eines erfolgreichen Antastens und Messvorgangs entsprechen.

Die Ablaufsequenz kann so vorteilhaft den Ablauf des Anlegens (Antastens), des Messens und des nachfolgenden Entfernens, mit anderen Worten ein Benutzen der Spannungsmesseinrichtung erkennen.

Gemäß einer bevorzugten Ausführungsform der Spannungsmesseinrichtung entspricht das erwartete Beschleunigungsprofil zum Anstoßen der Spannungsmesseinheit einem Anstoßen an ein hartes Material und dadurch ist ein Bewegen der Spannungsmesseinheit an ein weiches Material oder durch ein Gas (Luft) von einem Anstoßen an ein hartes Material unterscheidbar.

Gemäß einer bevorzugten Ausführungsform der Spannungsmesseinrichtung ist die Steuereinrichtung ein Mikrokontroller ist und/oder umfasst einen nichtflüchtigen elektronischen Speicher.

Der Beschleunigungssensor kann über eine interne Kommunikation, beispielsweise über eine i2C-Kommunikation, mit der Steuereinrichtung verbunden sein.

An der Spannungsmesseinrichtung können die Einstellungen für den Beschleunigungssensor teilweise fest im Flash-Speicher hinterlegt sein und teilweise über das EEPROM konfigurierbar mit Voreinstellungen gespeichert sein.

Der Spannungsmesseinrichtung mit dem Spannungsermittlungsschritt kann eingeschaltet werden und danach kann an die Spannungsmesseinheit auf den Leiter, etwa auf eine Kupferschiene in einer Schaltanlage getastet werden, um diese auf Spannung zu überprüfen. Dieses Tasten kann dann vom Beschleunigungssensor detektiert werden.

Es kann anschließend überprüft werden, ob die Spannungsmesseinrichtung nicht auf den Boden gestellt wurde und anschließend überprüft werden, ob die Spannungsmesseinrichtung für eine kurze und vorbestimmte Zeit nicht bewegt wird. Auf diese Weise kann überprüft werden, ob der Anwender die Reaktion der Spannungsmesseinrichtung beobachtet. In dieser Zeit soll die Spannungsmesseinrichtung nicht von der auf zu Spannung überprüfende Schiene wegbewegt werden. Andernfalls kann ein Fehler erkannt und ausgelöst werden. Nach dieser Zeit soll die Spannungsmesseinrichtung wieder bewegt werden. Falls dies zutrifft, kann das mechanische Antasten als erfolgreich bewertet werden. Ansonsten, wenn die Spannungsmesseinrichtung nachträglich nicht wieder bewegt wird, kann ein Fehler erkannt und ausgelöst werden. Es kann vorteilhaft nach jedem Fehler die mechanische Antasterkennung von vorne gestartet werden.

Gemäß einer bevorzugten Ausführungsform der Spannungsmesseinrichtung ist die Steuerungseinrichtung dazu eingerichtet, während des Messvorgangs der Spannung deren Frequenz zu ermitteln oder anzunehmen und je nach ermittelter oder angenommener Frequenz eine vorbestimmte (etwa nach Schätzung festgesetzte) Detektionsschwelle zu setzen.

Gemäß einer bevorzugten Ausführungsform der Spannungsmesseinrichtung sind die vorbestimmten Detektionsschwellen in einem nichtflüchtigen elektronischen Speicher setzbar.

Gemäß einer bevorzugten Ausführungsform der Spannungsmesseinrichtung ist die Steuerungseinrichtung dazu eingerichtet, ein Vorhandensein oder ein Nichtvorhandensein einer Spannung oder einer Restspannung relativ zur jeweiligen vorbestimmten Detektionsschwelle und somit insbesondere bezogen auf die ermittelte oder angenommene Frequenz zu beziehen.

Erfindungsgemäß erfolgt bei dem Verfahren zum Prüfen einer Spannung an einem elektrischen Leiter mit einer Spannungsmesseinrichtung ein Erkennen eines Vorhandenseins und/oder einer Abwesenheit der Spannung in dem elektrischen Leiter mit der Spannungsmesseinheit; ein Erkennen eines Beschleunigungsmusters eines Antastvorgangs der Spannungsmesseinheit an den elektrischen Leiter über den Lage-/Beschleunigungssensor; ein Vergleichen des Antastvorgangs mit einem vorbestimmten und in der Steuerungseinrichtung hinterlegten Beschleunigungsmuster (und in Kombination mit der elektrischen Impulserkennung, welche zeitgleich erfolgt und logisch mit "und" verknüpft ist) durch die Steuerungseinrichtung und Erkennen und/oder Ausschließen eines erfolgreichen Antastens und im Falle eines erfolgreichen Antastens Erzeugen zumindest einer Information über eine von der Spannungsmesseinheit ermittelte Spannung in dem elektrischen Leiter; ein Übermitteln der zumindest einen Information über eine von der Spannungsmesseinheit ermittelte Spannung in dem elektrischen Leiter und über ein erfolgreiches Antasten an einen externen Empfänger über eine Drahtlosverbindung mit der Kommunikationsschnittstelle, wobei in einem automatisierten Vorgang bei einem erfolgreichen Antasten und einer erkannten Spannung im elektrischen Leiter die zumindest eine Information über die ermittelte Spannung und über ein erfolgreiches Antasten über die Kommunikationsschnittstelle übertragen wird und Zeit- und/oder Positionsinformationen über die erkannte Spannung erzeugt werden und in der Speichereinrichtung abgelegt und/oder über die Kommunikationsschnittstelle übertragen werden.

Gemäß einer bevorzugten Ausführungsform des Verfahrens wird der Antastvorgang und ein Überprüfen eines Vorhandenseins der Spannung im elektrischen Leiter als automatisierter und kombinierter Schritt durch die Steuerungseinrichtung ausgeführt und das erfolgreiche oder fehlgeschlagene Antasten und das Vorhandensein oder Nichtvorhandensein der Spannung im elektrischen Leiter über die Kommunikationsschnittstelle an einen externen Empfänger erfolgt und jeweils an einer Applikationssoftware am externen Empfänger angezeigt wird.

Gemäß einer bevorzugten Ausführungsform des Verfahrens wird der Antastvorgang zyklisch wiederholt bis ein erfolgreiches Antasten und ein Vorhandensein der Spannung erkannt wird, vorteilhaft automatisch.

Gemäß einer bevorzugten Ausführungsform des Verfahrens wird über einen vorbestimmten ersten Zeitraum ein Speicher des Beschleunigungssensors mit Beschleunigungsdaten über zumindest eine vorbestimmte Raumrichtung (beispielsweise längs zum Leiter hin) gefüllt, und über einen nachfolgenden vorbestimmten zweiten Zeitraum in einem Bypass-Modus werden die Beschleunigungsdaten aus dem Speicher des Beschleunigungssensors ausgelesen, wobei während des Bypass-Modus die Beschleunigungsdaten aus dem Speicher jeweils gegenüber einem vorbestimmten Bodenabstellprofil der Spannungsmesseinheit verglichen werden und ein Abstellen an einem Boden erkannt oder ausgeschlossen wird.

Der Flashspeicher kann ein interner Speicher der Steuereinrichtung sein, beispielsweise eines Mikrocontrollers, in dem das Ausführungsprogramm der Steuerung und der Anwendung der Spannungsmesseinrichtung liegen kann. Dieser Speicherbereich kann im Betrieb der Spannungsmesseinrichtung durch ein Update über Bluetooth verändert werden, beispielsweise ausschließlich auf diese Weise. In diesem Flashspeicher kann ein Click-Interruptmodus hinterlegt sein, wobei am Beschleunigungssensor ein Interrupt generiert werden kann, sobald auf einer Koordinatenachse einer Raumrichtung, etwa der X-Achse (Längs-Achse der Spannungsmesseinrichtung) eine Beschleunigungsschwelle (etwa im EEPROM hinterlegt) überschritten bzw. unterschritten wird, und nach einer definierten ClickZeit (beispielsweise im EEPROM hinterlegt) wieder unterschritten bzw. überschritten wird.

Wurde ein solcher Interrupt generiert, kann die Leitung zur Steuereinrichtung offen (aktiv) gehalten werden. Die Leitung kann so lange in diesem Zustand bleiben, bis die Steuereinrichtung über die Kommunikationsleitung den Interrupt zurücksetzt. Dieser Modus dient dafür zu detektieren, dass die Spannungsmesseinrichtung an ein hartes Material getastet wurde.

Wenn die Spannungsmesseinrichtung an ein weicheres Material als Kupfer getastet oder nur durch die Luft geschwungen wurde, wird der Interrupt, etwa nur durch die Erdbeschleunigung, nicht ausgelöst.

Des Weiteren kann im Flashspeicher der Füllvorgang des Speichers des Beschleunigungssensors gesetzt sein, mit anderen Worten der sogenannte "Stream to FIFO Mode" (First in First Out). Nach einem Click Interrupt können alle gemessenen Digitalwerte an Beschleunigung von drei Raumachsen mit hoher Abtastgeschwindigkeit, welche beispielsweise fest eingestellt auf 1,344 kHz gesetzt sein kann, in den internen Speicher des Beschleunigungssensors geschrieben werden, bis dieser voll ist (es können beispielsweise 32 Daten auf drei Achsen berücksichtigt werden, was auf 192 Byte resultieren kann).

Im sogenannten Bypass Modus werden die Messdaten nicht im Beschleunigungssensor gespeichert, sondern werden zu dieser Zeit aktiv von der Steuereinrichtung ausgelesen.

Betreffend die Auflösung der Messdaten kann der maximale Messbereich darauf eingestellt sein, bis zu einer +-4g-Beschleunigung mit einer Auflösung von 12bit zu erkennen.

Gemäß einer bevorzugten Ausführungsform des Verfahrens wird nach einem erfolgreichen Antasten an ein hartes Material des elektrischen Leiters eine Beschleunigungsruhephase während eines Messvorgangs mit vorgegebenen ersten Abtastintervallen überwacht, wobei ein Ruhephasenschwellenwert des Beschleunigungsprofils überwacht wird und eine dem Messvorgang nachfolgende Beschleunigungsphase mit vorgegebenen zweiten Abtastintervallen überwacht wird, wobei ein Beschleunigungsschwellenwert des Beschleunigungsprofils überwacht wird und beim Erkennen sowohl der Beschleunigungsruhephase als auch der nachfolgenden Beschleunigungsphase auf einen erfolgten Messvorgang rückgeschlossen wird und andernfalls in einen erneuten Antastvorgang gewechselt wird, wobei das erwartete Beschleunigungsprofil zum Anstoßen der Spannungsmesseinheit einem Anstoßen an ein hartes Material entspricht und dadurch ein Bewegen der Spannungsmesseinheit an ein weiches Material oder durch ein Gas von einem Anstoßen an ein hartes Material unterschieden wird.

Die zweiten Abtastintervalle (beispielsweise jeweils 100 ms) können jeweils länger sein als die ersten Abtastintervalle (beispielsweise jeweils 20 ms). Es kann für die ersten Abtastintervalle auch ein Rahmen von möglichen Werten vorliegen, welcher etwa 0 - 99*Abtastwert(oder digit) *20ms (vordefiniert) betragen kann, hierbei kann der Abtastwert etwa ein Vielfaches der 20 ms bestimmen. Bei drei Abtastwerten/intervallen kann ein erstes Abtastintervall 60 ms betragen, was einer Zeit entsprechen kann, in welcher die Spannungsmesseinheit in Ruhe an der Phase gehalten werden soll. Dabei kann erkannt werden, ob tatsächlich Spannung überprüft werden soll, oder ob nur versehentlich an ein hartes Material gestoßen wurde.

Für die zweiten Abtastintervalle können diese ebenfalls einen Wertebereich von 00 - 99 * Abtastwert (oder digit) *100ms annehmen. Hierbei kann der Abtastwert ein Vielfaches von 100 ms betragen. Diese Zeit kann das Antasten starten und die Antasterkennung nach dieser Zeit zurücksetzen mit einem Fehler "lang" von beispielsweise 50 * 100ms = 5 s. Durch diese Funktion kann erkannt werden, ob die Spannungsmesseinheit abgelegt wurde und durch den Stoß des Ablegens (auf den Boden) die Antastfunktion ausgelöst wurde.

Des Weiteren kann ein Bodenwert gesetzt sein, etwa zur Erkennung, ob beim Antasten eine Neigung zum Boden besteht. Dessen Werte können ((0 - 99) *Abtastwert (oder digit) *100)/10000 = d betragen. Ab einem statischen (bestimmten) d hinsichtlich einer Längsachse zum Leiter hin, kann eine Bodendetektion erkannt sein und ein Abtastwert von 50 kann daher zu einer Neigung von 45° führen.

Beispielsweise bei (00-99) *100) /10000 = g kann beim Wert 50 die Formel 0,5g ergeben, wobei 1g entspricht 90° das heißt der Prüfer erfährt in diesem Beispiel die komplette Erdbeschleunigung in Richtung seiner Längsachse. Somit entspricht 0,5g einem Neigungswinkel von 45°.

Gemäß einer bevorzugten Ausführungsform des Verfahrens umfasst der Messvorgang zur Ermittlung der Spannung ein Ermitteln einer Restspannung oder einer Arbeitsspannung mit einem Abgleich mit entsprechenden vorbestimmten Spannungs-Schwellenwerten in dem elektrischen Leiter, wobei gemäß dem Messvorgang zuerst überprüft wird, ob eine Spannungsänderung zwischen zwei Messwerten um einen der vorbestimmten Spannungs-Schwellenwerte entspricht und in diesem Fall ein Timer gestartet wird, in welchem überprüft wird, ob der Antastvorgang erfolgreich war und dann eine erfolgreiche Messung (um eine vorhandene Restspannung bzw. Arbeitsspannung zu erkennen) sowie Antasten erkannt wird und andernfalls der Messvorgang und/oder der Antastvorgang erneut gestartet wird.

Die Funktion der Antasterkennung kann zyklisch nach einer vorbestimmten Wiederholungszeit erneut gestartet werden.

Im einem Anfangszustand können alte Interrupts gelöscht werden und danach der Beschleunigungssensor in den "Stream to Fifo" Modus gewechselt werden. Dabei kann zusätzlich noch darauf gewartet werden bis der Interrupt des Beschleunigungssensors ausgelöst wird. Wurde der Interrupt ausgelöst, kann eine zugehörige (bestimmte) Pinleitung zuerst an der Steuereinrichtung, etwa am Mikrokontroller digital entprellt werden.

Es kann des Weiteren überprüft werden, falls ein sogenanntes "false signed flag" gesetzt ist, welches jedoch standardmäßig nicht gesetzt ist. Bei aktivierten false sign flag kann zwischen Antasten mit dem Griff des Spannungsprüfers und der Spitze unterschieden werden, indem zwischen einer Beschleunigung in eine positive mit einer Beschleunigung in eine negative Richtung unterschieden werden kann.

Falls dieses gesetzt ist, wird detektiert, ob die Spannungsmesseinrichtung mit der Handhabe nach vorne kontaktiert wird. Für den Fall, dass alle diese Bedingungen erfüllt sind, können alle Daten aus dem FIFO-Speicher ausgelesen werden und es wird in den Bypass Modus gewechselt. Anschließend kann beispielsweise 200 ms gewartet werden und dabei mit den gespeicherten Werten aktuell nichts gemacht werden. Mit diesen Werten kann man das

Antasten nochmal im Nachgang optimieren. Um die Genauigkeit der Antasterkennung zu erhöhen, können gespeicherten FIFO Werte auf ein (ermitteltes) Beschleunigungsmuster unmittelbar nach der Kontaktierung ausgewertet werden. Eine Optimierung kann durch ein Update über Bluetooth erfolgen.

Es kann für jede Messung überprüft werden, ob drei Beschleunigungswerte (also entsprechend drei Raumkoordinaten) über einer vorbestimmten Bodendetektionsschwelle liegen. Ist dies der Fall, kann ein entsprechender interner Fehler ausgelöst werden, da ein Abstellen auf dem Boden erkannt wurde, wonach wieder in den erneuten Analysemodus (etwa dem Abtastvorgang von vorne beginnend) gewechselt werden kann. Es kann beispielsweise nach der bereits erwähnten Wartezeit von 200 ms gegen den Bodenschwellwert verglichen werden und in den weiteren Messungen als Referenzwert genutzt werden, ob die Spannungsmesseinrichtung bewegt wird und ob der Bodenschwellenwert (Detektion des Abstellens auf dem Boden) erkannt wurde. Anschließend kann wieder 100 ms gewartet werden.

Es kann im weiteren Verlauf eine Ruhephase an dem Leiter, welche zur Messung nötig sein kann erkannt oder überprüft werden und nachfolgend eine Beschleunigungsphase überprüft werden, durch welche identifiziert werden kann, ob es sich um einen realen Messvorgang handelt, da dann die Spannungsmesseinrichtung wieder vom Leiter wegbewegt werden sollte.

Somit kann überprüft werden, ob die Spannungsmesseinrichtung am Leiter oder an der Schiene (Leiter) in Ruhe gehalten wurde. Die Zeit, über welche die Spannungsmesseinrichtung nicht in einer der Raumachsen, beispielsweise Längsrichtung zum Leiter hin und entlang der Spannungsmesseinrichtung (x-Achse) um eine Vorgabe, beispielsweise 0,1 g bewegt werden soll, kann sich aus der im EEPROM hinterlegten vielfachen Zahl von ersten Abtastintervallen, beispielsweise mit einer Dauer der einzelnen Abtastintervalle von 20 ms berechnen. Wird diese Bedingung nicht erfüllt, wird der Fehler "zu kurz angetastet" ausgelöst und es wird in den ursprünglichen "Analysis" Zustand des Abtastvorgangs gewechselt. Wurde diese Bedingung erfüllt, kann danach an allen 10 ms Zeitabständen mit dann zweiten Abtastintervallen (etwa mit einer Dauer von jeweils 100 ms) verglichen werden, ob die Spannungsmesseinrichtung um 0,1g oder mehr zum Referenzwert bewegt wurde. Wurde dieser während der Zeit bewegt, wird das mechanische Antasten als erfolgreich bewertet und in den Spannungsanalyse Zustand gewechselt. Wird der Prüfer zu lange ohne Bewegung gehalten, wird ein Fehler ausgelöst und in den ursprünglichen Analyse-Modus zur Abtasterkennung gewechselt. Es kann das Ergebnis des mechanischen

Antastens dem Benutzer über die Kommunikationsschnittstelle und die Applikationssoftware an dem externen Empfänger mitgeteilt werden. Dazu kann ein Flag (Statusindikator eines Zustands) gesetzt werden um die Kombination mit dem elektrischen Messvorgang zu ermöglichen. Nach beispielsweise 20 ms (Zusatzzeit) wird dieses Flag wieder zurückgesetzt, falls kein elektrisches Antasten (Messvorgang) stattfand oder zum Vorhandenseins der Spannung/Restspannung führte und die Zustandsautomat kann wieder von vorne beginnen.

Es können vorteilhaft auch interne Fehler gesetzt und berücksichtigt werden, insbesondere kann beim click Interrupt erkannt werden, dass die Spannungsmesseinrichtung nicht an ein weicheres Material als Kupfer gestoßen wird und nur durch schnelle Bewegungen in der Luft ein Interrupt ausgelöst wird.

Dazu kann auch ein "To Short Fehler" gesetzt werden, wonach erkannt wird, dass die Spannungsmesseinrichtung nur versehentlich an ein Material gestoßen wurde, ein "To Long Fehler" gesetzt werden, wonach erkannt wird, dass die Spannungsmesseinrichtung hingelegt wurde, und/oder ein "Boden Fehler" gesetzt wurde, wonach erkannt wird, dass die Spannungsmesseinrichtung auf den Boden gestellt wurde. All diese Fehler können aus Schwellenwerten zum Beschleunigungsprofil herausgelesen werden.

Der Messvorgang zur Spannungsmessung kann auch als eine elektrische Impulserkennung beschrieben werden, welche zur Erkennung in der Steuereinrichtung implementiert sein kann. Dabei können erlaubte Pegelwerte 1-9 auftreten. Ein solcher Wert entspricht beispielsweise einer Änderung von einem Digit am Eingang des ADC. Wenn dieser Wert beispielsweise größer ist als 1-9*10, wird die Impulsmessung getriggert. Voreingestellt kann "2" sein. Eine Minimalzeit zwischen 2 Phasen in sec kann 1-9 betragen, etwa eine Rücksetzzeit der Impulsmessung. Voreingestellt kann "5" sein.

Für die elektrische Impulserkennung kann es einen separaten Zustandsautomaten geben. Dieser kann alle 1ms ausgeführt werden. Der Zustandsautomat für die elektrische Impulserkennung und der Zustandsautomat für die mechanische Antasterkennung können parallel ausgeführt werden . Im einem primären Zustand kann überprüft werden, ob es eine Spannungsänderung von einem Messwert zum nächsten um den im EEPROM hinterlegten Pegel gibt. Ist dies der Fall kann folglich ein Timer mit der in der EEPROM hinterlegten Zeit gestartet werden. Wird in dieser Zeit das mechanische Antasten erfolgreich ausgeführt, wird das Antasten mit erfolgreich bewertet und der Timer und das Flag werden zurückgesetzt. Andernfalls läuft der Timer aus. Als nächstes beginnt der Zustandsautomat wieder von vorne.

Am Spannungsprüfer kann über eine analoge Signalaufbereitung der gemessene Strom, welcher über die Prüfspitze des Spannungsprüfers fließt, in eine Spannung von beispielsweise 0-1 Volt umgewandelt werden. Diese Spannung kann über einen ADC (Analog Digital Converter) im Mikrocontroller digitalisiert werden mit einem Abtastintervall von 1 ms und einer Auflösung von 12 Bit. Diese Digitalwerte werden zur Spannungsüberprüfung und für die Impulserkennung verwendet. Im EEPROM kann der Erkennungslevel für die Impulserkennung von Stufe 1-9 geändert werden. Stufe 1 entspricht beispielsweise einer Änderung von 10 Digits von einem Abtastwert zum nächsten. Ändert sich beispielsweise die Spannung am Eingang von 500 mV (entspricht 2048 digit) zu 503 mV (entspricht 2059 digit) innerhalb von 1ms wird die Impulserkennung angesprochen.

Im Allgemeinen kann eine Kombination des Messvorgangs (elektrische Impulserkennung) und dem mechanischen Antastens erfolgen. Für die Kombination dieser kann es eine separate Funktion in der Steuereinrichtung geben, welche auch alle 1ms aufgerufen werden kann. Hier können die Flags beider Statemachines zyklisch überprüft werden. Falls beide Flags aktiv sind, wird das Antasten als erfolgreich bewertet und die Flags der jeweiligen State Machines werden zurückgesetzt. Sobald eine erfolgreiche Bewertung erfolgte, kann diese Information dem Benutzer über die Kommunikationsschnittstelle, etwa per Bluetooth, an den externen Empfänger, etwa ein Smartphone, mitgeteilt und auch im Ereignisspeicher des EEPROMs gespeichert werden.

Gemäß einer bevorzugten Ausführungsform des Verfahrens wird während des Messvorgangs der Spannung deren Frequenz ermittelt oder angenommen und je nach ermittelter oder angenommener Frequenz eine vorbestimmte Detektionsschwellen gesetzt und/oder angewandt und über eine Applikationssoftware eines externen Empfängers über die Kommunikationsschnittstelle zwischen einem ersten und einem zweiten Spannungsnennbereich des Messvorgangs umgeschaltet, wobei die vorbestimmte Detektionsschwelle dem jeweiligen Spannungsnennbereich zugehört. Der Nennspannungsbereich kann auch über einen Taster am Gerät selbst umgeschaltet werden.

In der Spannungsmesseinrichtung kann eine Frequenzerkennung oder Frequenzbestimmung (auch als Festsetzung) implementiert sein. Dabei kann die Frequenz während der Spannungsdetektion gemessen oder nach Schätzung festgelegt werden. Anschließend kann je nach gemessener oder angenommener Frequenz eine zugehörige Detektionsschwelle gesetzt werden, welche zur angenommenen Frequenz passen kann in jenem Sinne, dass das Vorhandensein oder Nichtvorhandensein der Spannung an dieser Detektionsschwelle für eine Spannung mit der jeweiligen angenommenen oder gemessenen Frequenz anwendbar sein kann. Dadurch kann es möglich sein den Spannungswert immer auf die richtige Schwelle zu prüfen. Bei jeder Anlage kann dann, unabhängig von der Frequenz, eine zutreffende Aussage getroffen werden, ob die Anlage spannungsführend oder freigeschalten ist.

Es können allgemein eine vorbestimmte Anzahl von Detektionsschwellen in der Speichereinrichtung gesetzt werden, beispielsweise können sechs verschiedene Detektionsschwellen ins EEPROM abgespeichert werden. Da beispielsweise über einen Taster an der Spannungsmesseinrichtung oder über eine Applikationssoftware vom externen Empfänger aus zwischen zwei vorbestimmten Nennspannungsbereichen umschaltet werden kann, können daher für jede Frequenz (beispielsweise $16\frac{2}{3}$ Hz, 50 Hz und 60 Hz) zwei Schwellen abgespeichert werden. Gleichzeitig kann für jeden Nennspannungsbereich eine Standardfrequenz abgespeichert werden.

Gemäß einer bevorzugten Ausführungsform des Verfahrens wird je nach Spannungsnennbereich eine Standardfrequenz angenommen und die vorbestimmte Detektionsschwelle zu dieser Standardfrequenz gesetzt.

Gemäß einer bevorzugten Ausführungsform des Verfahrens wird eine vorbestimmte Frequenz angenommen und die vorbestimmte Detektionsschwelle zu dieser vorbestimmten Frequenz gesetzt, wobei während des Messvorgangs weiterhin die Frequenz überprüft und mit der vorbestimmten Frequenz verglichen wird und bei Abweichung eine Fehlermeldung ausgegeben wird.

Gemäß einer bevorzugten Ausführungsform des Verfahrens wird die Frequenz gleichzeitig mit dem Messvorgang gemessen und die vorbestimmte Detektionsschwelle zu dieser gemessenen Frequenz gesetzt und nach einer erkannten Spannung oberhalb der vorbestimmten Detektionsschwelle die Frequenz erneut gemessen und überprüft wird und bei Abweichung eine Fehlermeldung ausgegeben wird.

Gemäß einer bevorzugten Ausführungsform des Verfahrens wird die Frequenz gleichzeitig mit dem Messvorgang gemessen und wenn die Frequenz außerhalb von erwarteten Frequenzwerten liegt, wird ein jeweiliger Standardwert für die vorbestimmte Detektionsschwelle gesetzt, je nachdem ob die Frequenz größer oder kleiner der erwarteten Frequenzwerte ist, ansonsten werden jeweilige vorbestimmte Detektionsschwellen gesetzt, die den jeweiligen gemessenen Frequenzen zugehören.

Gemäß einer bevorzugten Ausführungsform des Verfahrens erfolgt die Frequenzmessung innerhalb einer vorbestimmten Zeit um eine erfolgreiche Frequenzmessung zu erhalten, ansonsten wird die vorbestimmte Detektionsschwelle auf eine vorbestimmte kritische Detektionsschwelle gesetzt. Die kritische Detektionsschwelle kann etwa die kleinste Detektionsschwelle über die 2 oder 3 aktivierten Frequenzen in dem jeweiligen Nennspannungsbereichen sein. Dadurch kann ein sicheres Ergebnis erzielt werden. Es kann dann etwa fälschlicherweise Spannung vorhanden detektiert werden anstatt Spannung frei.

Erfindungsgemäß kann die Spannungsmesseinrichtung zum Prüfen einer Spannung an einem elektrischen Leiter umfassen: eine Spannungsmesseinheit, mit welcher ein Vorhandensein und/oder eine Abwesenheit der Spannung in dem elektrischen Leiter erkennbar ist; eine Steuerungseinrichtung, welche in der Spannungsmesseinheit umfasst oder mit dieser verbunden ist und mit dieser zumindest eine Information über eine von der Spannungsmesseinheit ermittelten Spannung in dem elektrischen Leiter erzeugbar ist; und eine Kommunikationsschnittstelle, welche mit der Steuerungseinrichtung zur Datenübertragung verbunden ist und wobei mit der Kommunikationsschnittstelle die zumindest eine Information über eine von der Spannungsmesseinheit ermittelten Spannung in dem elektrischen Leiter über eine Drahtlosverbindung übermittelbar ist, wobei in einem automatisierten Vorgang bei einer erkannten Spannung im elektrischen Leiter die zumindest eine Information über die ermittelte Spannung über die Kommunikationsschnittstelle übertragbar ist und Zeit- und/oder Positionsinformationen über die erkannte Spannung erzeugbar und in einer Speichereinrichtung ablegbar und/oder über die Kommunikationsschnittstelle übertragbar sind, wobei die Steuerungseinrichtung dazu eingerichtet ist, während des Messvorgangs der Spannung deren Frequenz zu ermitteln oder anzunehmen und je nach ermittelter oder angenommener Frequenz eine vorbestimmte Detektionsschwelle zu setzen.

Gemäß einer bevorzugten Ausführungsform der Spannungsmesseinrichtung kann die vorbestimmte Detektionsschwelle in einem nichtflüchtigen elektronischen Speicher setzbar sein.

Gemäß einer bevorzugten Ausführungsform der Spannungsmesseinrichtung kann die Steuerungseinrichtung dazu eingerichtet sein, ein Vorhandensein oder ein Nichtvorhandensein einer Spannung oder einer Restspannung relativ zur jeweiligen vorbestimmten Detektionsschwelle und somit insbesondere bezogen auf die ermittelte oder angenommene Frequenz zu beziehen.

Erfindungsgemäß erfolgt bei dem Verfahren zum Prüfen einer Spannung an einem elektrischen Leiter mit einer erfindungsgemäßen Spannungsmesseinrichtung ein Erkennen eines Vorhandensein und/oder einer Abwesenheit der Spannung in dem elektrischen Leiter mit der Spannungsmesseinheit; ein Erzeugen zumindest einer Information über eine von der Spannungsmesseinheit ermittelte Spannung in dem elektrischen Leiter; ein Übermitteln der zumindest einen Information über eine von der Spannungsmesseinheit ermittelte Spannung in dem elektrischen Leiter an einen externen Empfänger über eine Drahtlosverbindung mit der Kommunikationsschnittstelle, wobei in einem automatisierten Vorgang bei einer erkannten Spannung im elektrischen Leiter die zumindest eine Information über die ermittelte Spannung und über die Kommunikationsschnittstelle übertragen wird und Zeit- und/oder Positionsinformationen über die erkannte Spannung erzeugt werden und in der Speichereinrichtung abgelegt und/oder über die Kommunikationsschnittstelle übertragen werden, wobei weiterhin während des Messvorgangs der Spannung deren Frequenz ermittelt oder angenommen wird und je nach ermittelter oder angenommener Frequenz eine vorbestimmte Detektionsschwellen gesetzt und/oder angewandt wird.

Gemäß einer bevorzugten Ausführungsform des Verfahrens wird über eine Applikationssoftware eines externen Empfängers über die Kommunikationsschnittstelle zwischen einem ersten und einem zweiten Spannungsnennbereich des Messvorgangs umgeschaltet wird, wobei die vorbestimmte Detektionsschwelle dem jeweiligen Spannungsnennbereich zugehört.

Gemäß einer bevorzugten Ausführungsform des Verfahrens wird je nach Spannungsnennbereich eine Standardfrequenz angenommen und die vorbestimmte Detektionsschwelle zu dieser Standardfrequenz gesetzt.

Gemäß einer bevorzugten Ausführungsform des Verfahrens wird eine vorbestimmte Frequenz angenommen und die vorbestimmte Detektionsschwelle zu dieser vorbestimmten Frequenz gesetzt, wobei während des Messvorgangs weiterhin die Frequenz überprüft und mit der vorbestimmten Frequenz verglichen wird und bei Abweichung eine Fehlermeldung ausgegeben wird.

Gemäß einer bevorzugten Ausführungsform des Verfahrens wird die Frequenz gleichzeitig mit dem Messvorgang gemessen wird und die vorbestimmte Detektionsschwelle zu dieser gemessenen Frequenz gesetzt wird und nach einer erkannten Spannung oberhalb der vorbestimmten Detektionsschwelle die Frequenz erneut gemessen und überprüft wird und bei Abweichung eine Fehlermeldung ausgegeben wird.

Gemäß einer bevorzugten Ausführungsform des Verfahrens wird die Frequenz gleichzeitig mit dem Messvorgang gemessen wird und wenn die Frequenz außerhalb von erwarteten Frequenzwerten liegt, wird ein jeweiliger Standardwert für die vorbestimmte Detektionsschwelle gesetzt, je nachdem ob die Frequenz größer oder kleiner der erwarteten Frequenzwerte ist, ansonsten werden jeweilige vorbestimmte Detektionsschwellen gesetzt, die den jeweiligen gemessenen Frequenzen zugehören.

Gemäß einer bevorzugten Ausführungsform des Verfahrens erfolgt die Frequenzmessung innerhalb einer vorbestimmten Zeit um eine erfolgreiche Frequenzmessung zu erhalten, ansonsten wird die vorbestimmte Detektionsschwelle auf eine vorbestimmte kritische Detektionsschwelle gesetzt.

Die vorliegende Erfindung wird nachfolgend anhand der in den schematischen Figuren angegebenen Ausführungsbeispiele näher erläutert. Es zeigen dabei:

Fig. 1 eine schematische Ansicht einer Spannungsmesseinrichtung gemäß einem Ausführungsbeispiel der vorliegenden Erfindung;

Fig. 2 eine schematische Darstellung eines Verfahrens zum Prüfen einer Spannung an einem elektrischen Leiter mit einer Spannungsmesseinrichtung gemäß einem Ausführungsbeispiel der vorliegenden Erfindung;

Fig. 3 eine schematische Darstellung von Detailschritten des Verfahrens gemäß einem weiteren Ausführungsbeispiel der vorliegenden Erfindung;

Fig. 4 eine schematische Darstellung von Detailschritten des Verfahrens gemäß einem weiteren Ausführungsbeispiel der vorliegenden Erfindung;

Fig. 5 eine schematische Darstellung von Detailschritten des Verfahrens gemäß einem weiteren Ausführungsbeispiel der vorliegenden Erfindung;

Fig. 6 eine schematische Darstellung von Detailschritten des Verfahrens gemäß einem weiteren Ausführungsbeispiel der vorliegenden Erfindung

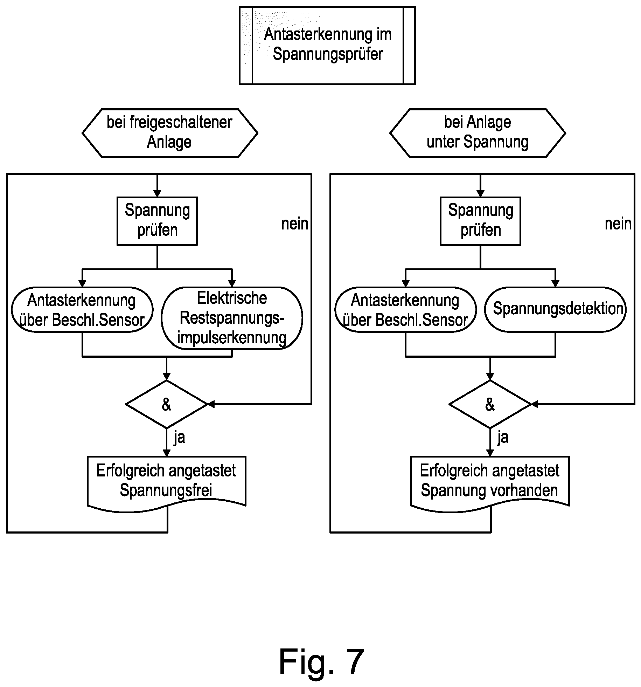

Fig. 7 eine schematische Darstellung von Detailschritten des Verfahrens gemäß einem weiteren Ausführungsbeispiel der vorliegenden Erfindung; und

Fig. 8 eine Darstellung eines Beschleunigungsprofils
für das mechanische Antasten für ein hartes
Material und für ein weiches Material.

Weitere Merkmale und Vorteile von Ausführungsformen der Erfindung ergeben sich aus der nachfolgenden Beschreibung mit Bezug auf die beigefügten
Zeichnungen. Andere Ausführungsformen und viele der
genannten Vorteile ergeben sich im Hinblick auf die
Zeichnungen. Die Elemente der Zeichnungen sind nicht
notwendigerweise maßstabsgetreu zueinander gezeigt.
In den Figuren der Zeichnung sind gleiche,
funktionsgleiche und gleich wirkende Elemente, Merkmale und Komponenten - sofern nichts anderes ausgeführt ist - jeweils mit denselben Bezugszeichen versehen.

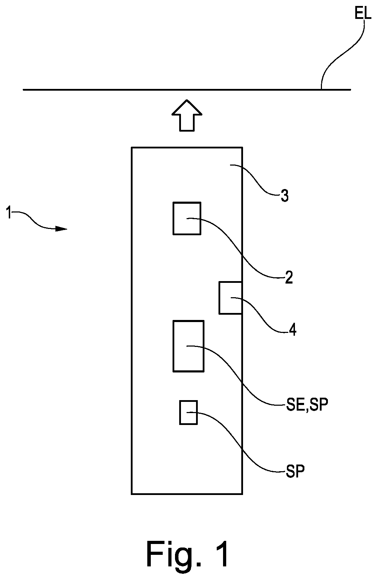

Die Fig. 1 zeigt eine schematische Ansicht einer
Spannungsmesseinrichtung gemäß einem Ausführungsbeispiel der vorliegenden Erfindung.
In der Fig. 1 wird die Spannungsmesseinrichtung 1 zum Prüfen einer Spannung an einem elektrischen Leiter EL symbolisch gezeigt. Diese umfasst eine
Spannungsmesseinheit 3, mit welcher ein Vorhandensein und/oder eine Abwesenheit der Spannung in dem
elektrischen Leiter EL erkennbar ist; einen Lage-/Beschleunigungssensor 2, mit welchem ein Beschleunigungsmuster eines Antastvorgangs der Spannungsmesseinheit an den elektrischen Leiter EL erkennbar
ist; eine Steuerungseinrichtung SE, welche in der Spannungsmesseinheit 3 umfasst ist und mit welcher der
Antastvorgang mit einem vorbestimmten und in der
Steuerungseinrichtung SE hinterlegten Beschleunigungsmuster und in Kombination mit einer elektrischen
Impulserkennung, welche zeitgleich erfolgen kann (und
logisch mit "und" verknüpft sein kann) für ein erfolgreiches Antasten vergleichbar ist und ein erfolgreiches Antasten erkennbar und/oder ausschließbar ist und im Falle
eines erfolgreichen Antastens zumindest eine Information über eine von der Spannungsmesseinheit 3 ermittelten Spannung in dem elektrischen Leiter EL erzeugbar
ist.- Des Weiteren umfasst die Spannungsmesseinrichtung 1 eine Speichereinrichtung SP, welche in der
Steuerungseinrichtung SE umfasst oder mit der Steuereinrichtung SE verbindbar ist und in welcher vorbestimmte Daten über ein Beschleunigungsmuster der Spannungsmesseinheit 3 hinterlegbar sind oder hinterlegt
sind; und eine Kommunikationsschnittstelle 4, welche
mit der Steuerungseinrichtung SE zur Datenübertragung
verbunden ist und wobei mit der Kommunikationsschnittstelle 4 die zumindest eine Information über eine von der
Spannungsmesseinheit 3 ermittelten Spannung in dem elektrischen Leiter EL an einen externen Empfänger über
eine Drahtlosverbindung übermittelbar ist, wobei in einem automatisierten Vorgang bei einem erfolgreichen
Antasten und einer erkannten Spannung im elektrischen
Leiter die zumindest eine Information über die ermittelte
Spannung und über ein erfolgreiches Antasten über die
Kommunikationsschnittstelle 4 übertragbar ist und Zeit-
und/oder Positionsinformationen über die erkannte
Spannung erzeugbar und in der Speichereinrichtung
SP ablegbar und/oder über die Kommunikationsschnittstelle 4 übertragbar sind.

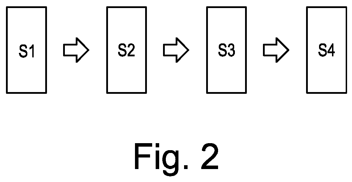

Die Fig. 2 zeigt eine schematische Darstellung
eines Verfahrens zum Prüfen einer Spannung an einem
elektrischen Leiter mit einer Spannungsmesseinrichtung
gemäß einem Ausführungsbeispiel der vorliegenden Erfindung.
Bei dem Verfahren zum Prüfen einer Spannung
an einem elektrischen Leiter mit einer Spannungsmesseinrichtung erfolgt ein Erkennen S1 eines Vorhandenseins und/oder einer Abwesenheit der Spannung in dem
elektrischen Leiter mit der Spannungsmesseinheit; ein
Erkennen S2 eines Beschleunigungsmusters eines Antastvorgangs der Spannungsmesseinheit an den elektrischen Leiter über den Lage-/Beschleunigungssensor;
ein Vergleichen S3 des Antastvorgangs mit einem vorbestimmten und in der Steuerungseinrichtung hinterlegten Beschleunigungsmuster durch die Steuerungseinrichtung und Erkennen und/oder Ausschließen eines
erfolgreichen Antastens und im Falle eines erfolgreichen
Antastens Erzeugen zumindest einer Information über
eine von der Spannungsmesseinheit ermittelte Spannung in dem elektrischen Leiter; ein Übermitteln S4
der zumindest einen Information und über ein erfolgreiches Antasten über eine von der Spannungsmesseinheit
ermittelte Spannung in dem elektrischen Leiter an einen
externen Empfänger über eine Drahtlosverbindung mit
der Kommunikationsschnittstelle, wobei in einem automatisierten Vorgang bei einem erfolgreichen Antasten
und einer erkannten Spannung im elektrischen Leiter die
zumindest eine Information über die ermittelte Spannung
über die Kommunikationsschnittstelle übertragen wird
und Zeit- und/oder Positionsinformationen über die erkannte Spannung erzeugt werden und in der Speichereinrichtung abgelegt und/oder über die Kommunikationsschnittstelle übertragen werden.

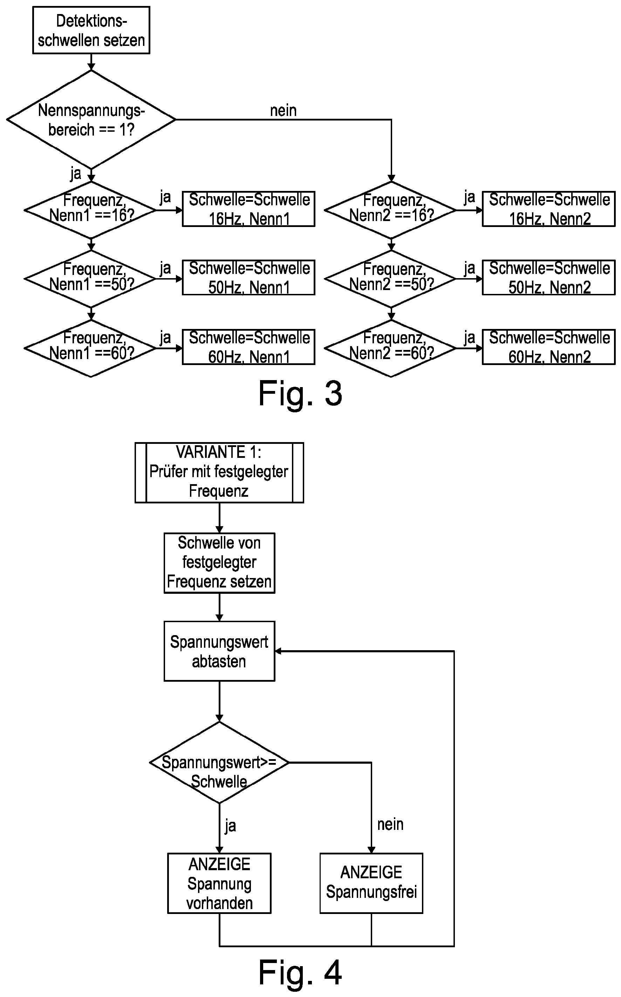

Die Fig. 3 zeigt eine schematische Darstellung
von Detailschritten des Verfahrens gemäß einem weiteren Ausführungsbeispiel der vorliegenden Erfindung.
Nach der Fig. 3 ist verdeutlicht, wie nach einem
Beispiel die zugehörige (richtige) Detektionsschwelle vor
bzw. während dem Programmablauf gesetzt werden
kann. Bei einem Prüfer mit fester Frequenz kann zuerst
überprüft werden, welcher Nennspannungsbereich aktiv
ist (beispielsweise durch Aufforderung zur manuellen
Eingabe, etwa über die Applikationssoftware oder am
Taster). Das Programm kann die Findung der Nennfrequenz (auch nach der Eingabe) über eine "Ja/Nein"-Abfrage führen. Danach kann die im EEPROM angenommene (hinterlegte) Frequenz gesetzt bzw. angewendet werden. Je nach Frequenz wird dann die richtige Schwelle gesetzt. Mit anderen Worten kann im Programmablauf abgefragt werden, welche Frequenz anliegt, wobei auch diese manuell gesetzt werden kann, etwa über die Applikationssoftware. Dann kann zur angenommenen Frequenz die entsprechend zugehörige und gespeicherte Detektionsschwelle genutzt werden. Dieser Vorgang kann für die jeweilige Nennspannung angewandt werden.

Das gleiche Verfahren kann auch angewendet, wenn eine automatische Frequenzerkennung vorhanden und aktiviert ist. Hierbei wird die Frequenz nicht fest gesetzt, sondern wird fortlaufend durch eine Frequenzmessung während der Spannungsdetektion bestimmt und somit die richtigen Schwellen gesetzt.

Die Fig. 4 zeigt eine schematische Darstellung von Detailschritten des Verfahrens gemäß einem weiteren Ausführungsbeispiel der vorliegenden Erfindung.

Nach der in der Fig. 4 gezeigten Variante der Frequenzannahme/Frequenzerkennung kann für jeden Nennspannungsbereich eine Standardfrequenz festgelegt (angenommen) werden.

Dabei kann anfangs die Detektionsschwelle je nach Frequenz und Nennspannungsbereich gesetzt werden. Während der Spannungsdetektion kann dann immer, unabhängig von der gemessenen Frequenz, gegen diese feste und gesetzte Detektionsschwelle geprüft werden.

Anschließend kann der Spannungswert mit dieser Schwelle verglichen werden. Für den Fall, dass der ermittelte Spannungswert kleiner als die festgelegte Detektionsschwelle ist, kann die Anlage als freigeschalten erkannt werden. Ist der Spannungswert allerdings größer oder gleich der festgelegten Detektionsschwelle, wird die Anlage als nicht spannungsfrei bewertet und es wird Spannung als vorhanden angezeigt, vorteilhaft an der Applikationssoftware. Eine Frequenzabweichung wird hier nicht festgestellt und somit auch keine Fehlermeldung übermittelt.

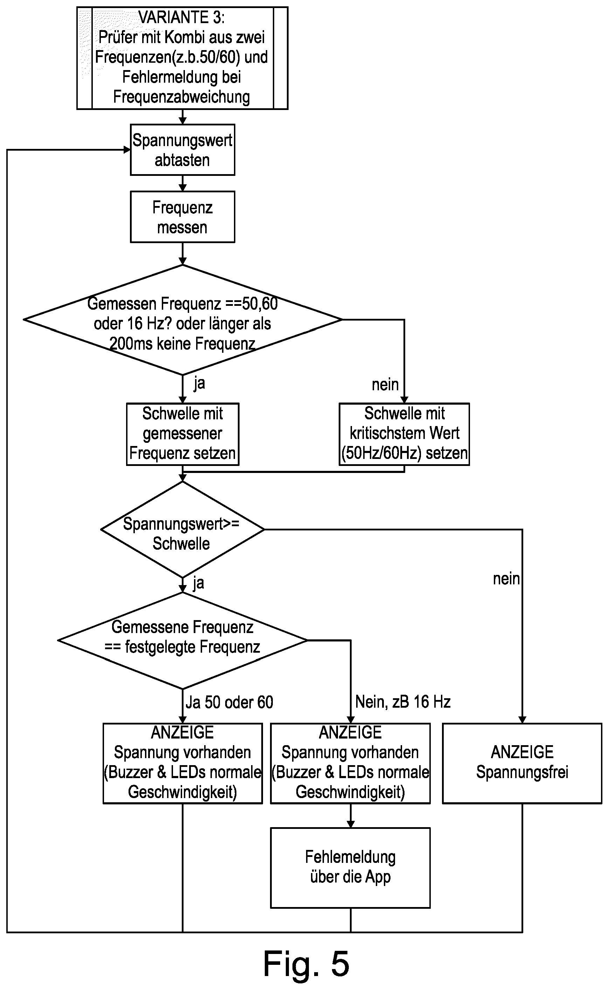

Die Fig. 5 zeigt eine schematische Darstellung von Detailschritten des Verfahrens gemäß einem weiteren Ausführungsbeispiel der vorliegenden Erfindung.

Nach dem Ablauf der Fig. 5 kann beispielsweise gleichzeitig eine Spannung mit einer Frequenz von 50 Hz und eine Spannung mit 60 Hz gemessen werden, wobei während der Spannungsdetektion gleichzeitig die Frequenz gemessen werden kann. Eine Detektionsschwelle kann dann entsprechend der gemessenen Frequenz gesetzt werden (zugeordnet werden, da vorbestimmt). Anschließend kann der Spannungswert mit dieser Detektionsschwelle verglichen werden. Wiederum gilt, dass falls der Spannungswert kleiner als die festgelegte Schwelle ist, die Anlage als freigeschalten bewertet werden kann und falls der Spannungswert größer oder gleich der festgelegten Schwelle ist, die Anlage nicht spannungsfrei bewertet wird und es Spannung "vorhanden" angezeigt werden kann.

Gleichzeitig kann überprüft werden, ob die gemessene Frequenz mit der festgelegten Frequenz (50 Hz / 60 Hz) übereinstimmt. Bei einer Frequenzdetektion von beispielsweise 16 Hz wird eine Fehlermeldung an die Applikationssoftware übermittelt und gleichzeitig kann ein Buzzer an der Spannungsmesseinrichtung beispielsweise mit der doppelten Geschwindigkeit piepsen und Warnleuchten (LEDs) ebenfalls mit doppelter Geschwindigkeit blinken (verglichen mit einem Normalbetrieb bei erwarteter Frequenz), um die Frequenzabweichung anzuzeigen.

In einer Abwandlung dazu (nicht gezeigt) kann für jeden Nennspannungsbereich eine Frequenz (z.B. $16\frac{2}{3}Hz$) festgelegt werden und während der Spannungsdetektion gleichzeitig die Frequenz gemessen werden. Dazu kann eine Detektionsschwelle entsprechend der gemessenen Frequenz gesetzt werden (nach einer Vorgabe zugeordnet werden).

Anschließend kann der Spannungswert wieder mit dieser Detektionsschwelle verglichen werden.

Gleichzeitig kann noch überprüft werden, ob die gemessene Frequenz mit der festgelegten Frequenz übereinstimmt. Bei einer erkannten Frequenzabweichung kann eine Fehlermeldung an die Applikationssoftware übermittelt werden und die Aktivität von Buzzer und Warnleuchten angepasst werden (siehe oben).

Es kann beispielsweise auch gegeben sein, dass die Frequenzmessung in einer vorgegebenen Dauer von beispielsweise 200ms erfolgen soll. Wird in der Zeit keine Frequenz erkannt oder ist die Frequenz außerhalb der vorbestimmten Bereiche (etwa 16 Hz, 50 Hz, 60 Hz), dann kann die Detektionsschwelle auf die kleinere bzw. kritischere Schwelle, der zwei festgelegten Frequenzen, (50Hz/ 60Hz) gesetzt werden. Bei welchen Frequenzen eine Fehlermeldung erscheint und gegen welche geprüft werden soll, kann im EEPROM individuell je Messbereich konfiguriert werden.

Es kann zudem möglich sein, den Anwender zu informieren, falls die Frequenzerkennung keine passende Frequenz detektiert hat. Dies ist aber bei Bedarf im Nachgang mit einem Update über Bluetooth umsetzbar.

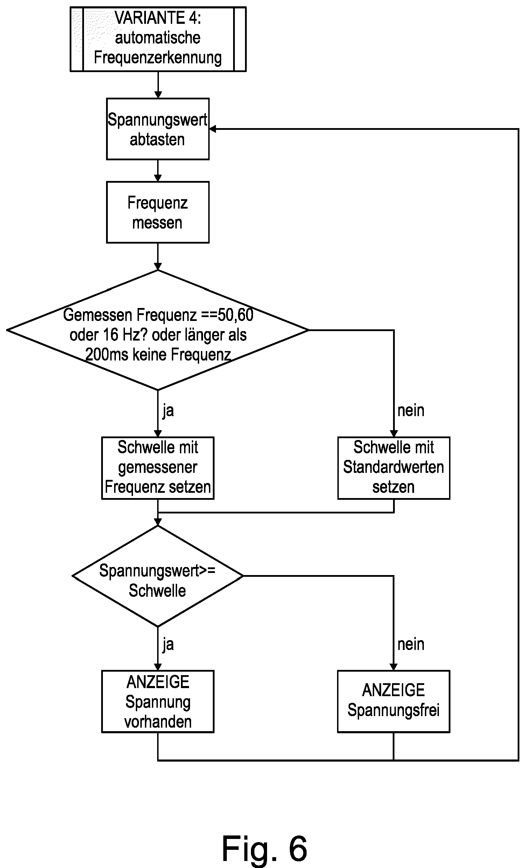

Die Fig. 6 zeigt eine schematische Darstellung von Detailschritten des Verfahrens gemäß einem weiteren Ausführungsbeispiel der vorliegenden Erfindung.

Nach der Fig. 6 kann in einer weiteren Ausführung mit Frequenzerkennung vorteilhaft während der Spannungsdetektion gleichzeitig die Frequenz gemessen werden. Liegt die gemessene Frequenz bei einer vorbestimmten Größe, beispielsweise 16 Hz, 50 Hz oder 60 Hz, kann die Detektionsschwelle entsprechend der gemessenen Frequenz, nach einer Vorgabe zugeordnet und gesetzt werden. Ist die Frequenz außerhalb dieser bestimmten Bereiche, können Standardwerte gesetzt, etwa je nachdem ob die Frequenz über oder unter den bestimmten Bereichen liegt. Anschließend kann der Spannungswert mit dieser Schwelle verglichen werden, ähnlich wie bei den anderen Beispielen. Die Frequenzmessung sollte in einer vorgegebenen Dauer von beispielsweise 200ms erfolgen. Wird in der Zeit keine Frequenz erkannt oder ist die Frequenz außerhalb der bestimmten Bereiche (etwa 16 Hz, 50 Hz, 60 Hz), dann wird die Detektionsschwelle auf die kleinere bzw. kritischere Schwelle, der zwei festgelegten Frequenzen, (50Hz/ 60Hz) gesetzt.

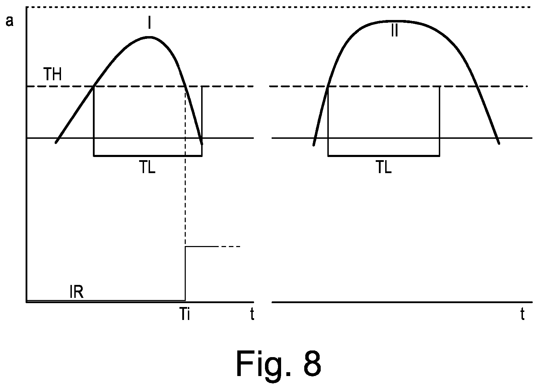

Die Fig. 8 zeigt eine Darstellung eines Beschleunigungsprofils für das mechanische Antasten für ein hartes Material und für ein weiches Material.

In Abhängigkeit mit der Zeit t kann während des Antastprozesses (mechanisch) die Beschleunigung der Spannungsmesseinheit für ein hartes Material (links) und ein weiches Material (rechts) der Fig. 8 ähneln. Dabei kann im Fall I für das harte Material ein Grenzwert TH der Beschleunigung a, welcher im EEPROM hinterlegt sein kann, während dem Beobachtungszeitraum TL zweimal erreicht werden, insbesondere einmal beim Beschleunigen überschritten und beim Abbremsen unterschritten, insbesondere zur Zeit Ti, welche innerhalb des Messintervalls TL liegen kann. Die Dauer des Messintervalls TL kann ebenfalls im EEPROM hinterlegt sein. Mit anderen Worten kann die Bewegung der Spannungsmesseinheit beim Antasten durch das harte Material derart schnell abgebremst werden, dass der Grenzwert TH durch die Beschleunigung bereits innerhalb des Messintervalls TL wieder unterschritten wird.

Im Falle II für ein weiches Material, kann durch die Weichheit des anzutastenden Materials die Abbremsung der Antastbewegung nicht schnell genug erfolgen, um die Beschleunigung a noch innerhalb des Messintervalls TL unterhalb des Grenzwertes TH zu verringern. Der Zeitpunkt des Unterschreitens des Grenzwerts TH liegt in diesem Fall außerhalb des Messintervalls TL.

Im Fall I kann bei Unterschreiten des Grenzwerts TH ein Click-Interrupt IR ausgelöst werden, wodurch die Auswertung der folgenden Beschleunigungswerte für ein erfolgreiches Antasten gestartet werden kann. ein erfolgreiches mechanisches Antasten registriert werden kann. Für das Messintervall TL können im EEPROM verschiedene Werte hinterlegt sein.

Das Messintervall kann in der Zeit über EEPROM Parameter variiert werden. Dabei kann man das Messintervall in der Länge von 1-9 Abtastintervallen wählen.

Obwohl die vorliegende Erfindung anhand des bevorzugten Ausführungsbeispiels vorstehend vollständig beschrieben wurde, ist sie darauf nicht beschränkt, sondern auf vielfältige Art und Weise modifizierbar.

**Patentansprüche**

1. Spannungsmesseinrichtung (1) zum Prüfen einer Spannung an einem elektrischen Leiter (EL), umfassend

   - eine Spannungsmesseinheit (3), mit welcher ein Vorhandensein und/oder eine Abwesenheit der Spannung in dem elektrischen Leiter (EL) erkennbar ist;
   - einen Lage-/Beschleunigungssensor (2), mit welchem ein Beschleunigungsmuster eines Antastvorgangs der Spannungsmesseinheit an den elektrischen Leiter (EL) erkennbar ist;
   - eine Steuerungseinrichtung (SE), welche in der Spannungsmesseinheit (3) umfasst oder mit dieser verbunden ist und mit welcher der Antastvorgang mit einem vorbestimmten und in der Steuerungseinrichtung (SE) hinterlegten Beschleunigungsmuster für ein erfolgreiches Antasten vergleichbar ist und in Kombination mit einer elektrischen Impulserkennung, welche zeitgleich erfolgt, ein erfolgreiches Antasten erkennbar und/oder ausschließbar ist und im Falle eines erfolgreichen Antastens zumindest eine Information über eine von der Spannungsmesseinheit (3) ermittelten Spannung in dem elektrischen Leiter (EL) und über ein erfolgreiches Antasten erzeugbar ist;
   - eine Speichereinrichtung (SP), welche in der Steuerungseinrichtung (SE) umfasst oder mit der Steuereinrichtung (SE) verbindbar ist und in welcher vorbestimmte Daten über ein Beschleunigungsmuster der Spannungsmesseinheit (3) hinterlegbar sind oder hinterlegt sind; und
   - eine Kommunikationsschnittstelle (4), welche mit der Steuerungseinrichtung (SE) zur Datenübertragung verbunden ist und wobei mit der Kommunikationsschnittstelle (4) die zumindest eine Information über eine von der Spannungsmesseinheit (3) ermittelten Spannung in dem elektrischen Leiter (EL) und über ein erfolgreiches Antasten an einen externen Empfänger (E) über eine Drahtlosverbindung übermittelbar ist, wobei in einem automatisierten Vorgang bei einem erfolgreichen Antasten und einer erkannten Spannung im elektrischen Leiter (EL) die zumindest eine Information über die ermittelte Spannung über die Kommunikationsschnittstelle (4) übertragbar ist und Zeit- und/oder Positionsinformationen über die erkannte Spannung erzeugbar und in der Speichereinrichtung (SP) ablegbar und/oder über die Kommunikationsschnittstelle (4) übertragbar sind.

2. Spannungsmesseinrichtung (1) nach Anspruch 1, bei welcher die Steuerungseinrichtung (SE) dazu eingerichtet ist, gemäß dem hinterlegten Beschleunigungsmuster oder zumindest eines weiteren Beschleunigungsmusters über den Beschleunigungssensor (2) einen Stoß in Richtung zum elektrischen Leiter (EL) hin und eine Bewegung vom elektrischen Leiter (EL) weg und/oder ein Absetzen der Spannungsmesseinheit (3) auf einer Unterlage zu erkennen und/oder das hinterlegte Beschleunigungsmuster eine Vorgabe über eine Beschleunigung umfasst, die einem erwarteten Beschleunigungsprofil zum Anstoßen der Spannungsmesseinheit (3) am elektrischen Leiter entspricht; und/oder eine Beschleunigungsruhephase während eines Messvorgangs umfasst und/oder eine dem Messvorgang nachfolgende Beschleunigungsphase umfasst, welche in Sequenz einer Verifizierung eines erfolgreichen Antastens und Messvorgangs entsprechen, und wobei das erwartete Beschleunigungsprofil zum Anstoßen der Spannungsmesseinheit einem Anstoßen an ein hartes Material entspricht und dadurch ein Bewegen der Spannungsmesseinheit (3) an ein weiches Material oder durch ein Gas von einem Anstoßen an ein hartes Material unterscheidbar ist.

3. Spannungsmesseinrichtung (1) nach einem der Ansprüche 1 oder 2, bei welcher die Steuerungseinrichtung (SE) dazu eingerichtet ist, während des Messvorgangs der Spannung deren Frequenz zu ermitteln oder anzunehmen und je nach ermittelter oder angenommener Frequenz eine vorbestimmte Detektionsschwelle zu setzen.

4. Spannungsmesseinrichtung (1) nach Anspruch 3, bei welcher die vorbestimmten Detektionsschwellen in einem nichtflüchtigen elektronischen Speicher setzbar sind und/oder die Steuerungseinrichtung (SE) dazu eingerichtet ist, ein Vorhandensein oder ein Nichtvorhandensein einer Spannung oder einer Restspannung relativ zur jeweiligen vorbestimmten Detektionsschwelle und somit insbesondere bezogen auf die ermittelte oder angenommene Frequenz zu beziehen.

5. Spannungsmesseinrichtung (1) zum Prüfen einer Spannung an einem elektrischen Leiter (EL), umfassend

   - eine Spannungsmesseinheit (3), mit welcher ein Vorhandensein und/oder eine Abwesenheit der Spannung in dem elektrischen Leiter (EL) erkennbar ist;
   - eine Steuerungseinrichtung (SE), welche in der Spannungsmesseinheit (3) umfasst oder mit dieser verbunden ist und mit dieser zumindest eine Information über eine von der Spannungsmesseinheit (3) ermittelten Spannung in dem elektrischen Leiter (EL) erzeugbar ist; und
   - eine Kommunikationsschnittstelle (4), welche mit der Steuerungseinrichtung (SE) zur Datenübertragung verbunden ist und wobei mit der Kommunikationsschnittstelle (4) die zumindest eine Information über eine von der Spannungsmesseinheit (3) ermittelten Spannung in dem elektrischen Leiter (EL) über eine Drahtlosverbindung übermittelbar ist, wobei in einem automatisierten Vorgang bei einer erkannten Spannung im elektrischen Leiter (EL) die zumindest eine Information über die ermittelte Spannung über die Kommunikationsschnittstelle (4) übertragbar ist und Zeit- und/oder Positionsinformationen über die erkannte Spannung erzeugbar und in einer Speichereinrichtung (SP) ablegbar und/oder über die Kommunikationsschnittstelle (4) übertragbar sind, wobei die Steuerungseinrichtung (SE) dazu eingerichtet ist, während des Messvorgangs der Spannung deren Frequenz zu ermitteln oder anzunehmen und je nach ermittelter oder angenommener Frequenz eine vorbestimmte Detektionsschwelle zu setzen.

6. Spannungsmesseinrichtung (1) nach Anspruch 5, bei welcher die vorbestimmten Detektionsschwellen in einem nichtflüchtigen elektronischen Speicher setzbar sind und/oder die Steuerungseinrichtung (SE) dazu eingerichtet ist, ein Vorhandensein oder ein Nichtvorhandensein einer Spannung oder einer Restspannung relativ zur jeweiligen vorbestimmten Detektionsschwelle und somit insbesondere bezogen auf die ermittelte oder angenommene Frequenz zu beziehen.

7. Verfahren zum Prüfen einer Spannung an einem elektrischen Leiter (EL) mit einer Spannungsmesseinrichtung (1) nach einem der Ansprüche 1 bis 4, umfassend die Schritte: Erkennen (S1) eines Vorhandensein und/oder einer Abwesenheit der Spannung in dem elektrischen Leiter (EL) mit der Spannungsmesseinheit (3);

   - Erkennen (S2) eines Beschleunigungsmusters eines Antastvorgangs der Spannungsmesseinheit an den elektrischen Leiter (EL) über den Lage-/Beschleunigungssensor (2);
   - Vergleichen (S3) des Antastvorgangs mit einem vorbestimmten und in der Steuerungseinrichtung (SE) hinterlegten Beschleunigungsmuster durch die Steuerungseinrichtung (SE) in Kombination mit einer elektrischen Impulserkennung, welche zeitgleich erfolgt, und Erkennen und/oder Ausschließen eines erfolgreichen Antastens und im Falle eines erfolgreichen Antastens Erzeugen zumindest einer Information über eine von der Spannungsmesseinheit (3) ermittelte Spannung in dem elektrischen Leiter (EL);
   - Übermitteln (S4) der zumindest einen Information über eine von der Spannungsmesseinheit (3) ermittelte Spannung in dem elektrischen Leiter (EL) und über ein erfolgreiches Antasten an einen externen Empfänger (E) über eine Drahtlosverbindung mit der Kommunikationsschnittstelle (4), wobei in einem automatisierten Vorgang bei einem erfolgreichen Antasten und einer erkannten Spannung im elektrischen Leiter (EL) die zumindest eine Information über die ermittelte Spannung und über ein erfolgreiches Antasten über die Kommunikationsschnittstelle (4) übertragen wird und Zeit- und/oder Positionsinformationen über die erkannte Spannung erzeugt werden und in der Speichereinrichtung (SP) abgelegt und/oder über die Kommunikationsschnittstelle (4) übertragen werden.

8. Verfahren nach Anspruch 7, bei welchem der Antastvorgang und ein Überprüfen eines Vorhandenseins der Spannung im elektrischen Leiter (EL) als automatisierter und kombinierter Schritt durch die Steuerungseinrichtung (SE) ausgeführt wird und das erfolgreiche oder fehlgeschlagene Antasten und das Vorhandensein oder Nichtvorhandensein der Spannung im elektrischen Leiter (EL) über die Kommunikationsschnittstelle (4) an einen externen Empfänger (E) erfolgt und jeweils an einer Applikationssoftware am externen Empfänger (E) angezeigt wird, und/oder
der Antastvorgang zyklisch wiederholt wird bis ein erfolgreiches Antasten und ein Vorhandensein der Spannung erkannt wird.

9. Verfahren nach Anspruch 8, bei welchem über einen vorbestimmten ersten Zeitraum ein Speicher des Beschleunigungssensors mit Beschleunigungsdaten über zumindest eine vorbestimmte Raumrichtung gefüllt wird, und über einen nachfolgenden vorbestimmten zweiten Zeitraum in einem Bypass-Modus die Beschleunigungsdaten aus dem Speicher des Beschleunigungssensors ausgelesen werden, wobei während des Bypass-Modus die Beschleunigungsdaten aus dem Speicher jeweils gegenüber einem vorbestimmten Bodenabstellprofil der Spannungsmesseinheit verglichen werden und ein Abstellen an einem Boden erkannt oder ausgeschlossen wird, und nach einem erfolgreichen Antasten an ein hartes Material des elektrischen Leiters (EL) eine Beschleunigungsruhephase während eines Messvorgangs mit vorgegebenen ersten Abtastintervallen überwacht wird, wobei ein Ruhephasenschwellenwert des Beschleunigungsprofils überwacht wird und eine dem Messvorgang nachfolgende Beschleunigungsphase mit vorgegebenen zweiten Abtastintervallen überwacht wird, wobei ein Beschleunigungsschwellenwert des Beschleunigungsprofils überwacht wird und beim Erkennen sowohl der Beschleunigungsruhephase als auch der nachfolgenden Beschleunigungsphase auf einen erfolgten Messvorgang rückgeschlossen wird und andernfalls in einen erneuten Antastvorgang gewechselt wird, wobei das erwartete Beschleunigungsprofil zum Anstoßen der Spannungsmesseinheit einem Anstoßen an ein hartes Material entspricht und dadurch ein Bewegen der Spannungsmesseinheit (3) an ein weiches Material oder durch ein Gas von einem Anstoßen an ein hartes Material unterschieden wird.

10. Verfahren nach einem der Ansprüche 7 bis 9, bei welchem der Messvorgang zur Ermittlung der Spannung ein Ermitteln einer Restspannung oder einer Arbeitsspannung mit einem Abgleich mit entsprechenden vorbestimmten Spannungs-Schwellenwerten in dem elektrischen Leiter (EL) umfasst, wobei gemäß dem Messvorgang zuerst überprüft wird, ob eine Spannungsänderung zwischen zwei Messwerten um einen der vorbestimmten Spannungs-Schwellenwerte entspricht und in diesem Fall ein Timer gestartet wird, in welchem überprüft wird, ob der Antastvorgang erfolgreich war und dann eine erfolgreiche Messung sowie Antasten erkannt wird und andernfalls der Messvorgang und/oder der Antastvorgang erneut gestartet wird.

11. Verfahren nach einem der Ansprüche 7 bis 10, bei welchem während des Messvorgangs der Spannung deren Frequenz ermittelt oder angenommen wird und je nach ermittelter oder angenommener Frequenz eine vorbestimmte Detektionsschwellen gesetzt und/oder angewandt wird und über eine Applikationssoftware eines externen Empfängers (E) über die Kommunikationsschnittstelle zwischen einem ersten und einem zweiten Spannungsnennbereich des Messvorgangs umgeschaltet wird, wobei die vorbestimmte Detektionsschwelle dem jeweiligen Spannungsnennbereich zugehört.

12. Verfahren nach Anspruch 11, bei welchem je nach Spannungsnennbereich eine Standardfrequenz angenommen wird und die vorbestimmte Detektionsschwelle zu dieser Standardfrequenz gesetzt wird, oder eine vorbestimmte Frequenz angenommen wird und die vorbestimmte Detektionsschwelle zu dieser vorbestimmten Frequenz gesetzt wird, wobei während des Messvorgangs weiterhin die Frequenz überprüft und mit der vorbestimmten Frequenz verglichen wird und bei Abweichung eine Fehlermeldung ausgegeben wird, oder bei welchem die Frequenz gleichzeitig mit dem Messvorgang gemessen wird und die vorbestimmte Detektionsschwelle zu dieser gemessenen Frequenz gesetzt wird und nach einer erkannten Spannung oberhalb der vorbestimmten Detektionsschwelle die Frequenz erneut gemessen und überprüft wird und bei Abweichung eine Fehlermeldung ausgegeben wird, wobei die Frequenzmessung innerhalb einer vorbestimmten Zeit erfolgt um eine erfolgreiche Frequenzmessung zu erhalten, ansonsten wird die vorbestimmte Detektionsschwelle auf eine vorbestimmte kritische Detektionsschwelle gesetzt, oder bei welchem die Frequenz gleichzeitig mit dem Messvorgang gemessen wird und wenn die Frequenz außerhalb von erwarteten Frequenzwerten liegt, wird ein jeweiliger Standardwert für die vorbestimmte Detektionsschwelle gesetzt, je nachdem ob die Frequenz größer oder kleiner der erwarteten Frequenzwerte ist, ansonsten werden jeweilige vorbestimmte Detektionsschwellen gesetzt, die den jeweiligen gemessenen Frequenzen zugehören, wobei die Frequenzmessung innerhalb einer vorbestimmten Zeit erfolgt um eine erfolgreiche Frequenzmessung zu erhalten, ansonsten wird die vorbestimmte Detektionsschwelle auf eine vorbestimmte kritische Detektionsschwelle gesetzt.

13. Verfahren zum Prüfen einer Spannung an einem elektrischen Leiter (EL) mit einer Spannungsmesseinrichtung (1) nach einem der Ansprüche 5 bis 6, umfassend die Schritte: Erkennen eines Vorhandensein und/oder einer Abwesenheit der Spannung in dem elektrischen Leiter (EL) mit der Spannungsmesseinheit (3);

> - Erzeugen zumindest einer Information über eine von der Spannungsmesseinheit (3) ermittelte Spannung in dem elektrischen Leiter (EL);
> - Übermitteln der zumindest einen Information über eine von der Spannungsmesseinheit (3) ermittelte Spannung in dem elektrischen Leiter (EL) an einen externen Empfänger (E) über eine Drahtlosverbindung mit der Kommunikationsschnittstelle (4), wobei in einem automatisierten Vorgang bei einer erkannten Spannung im elektrischen Leiter (EL) die zumindest eine Information über die ermittelte Spannung und über die Kommunikationsschnittstelle (4) übertragen wird und Zeit- und/oder Positionsinformationen über die erkannte Spannung erzeugt werden und in der Speichereinrichtung (SP) abgelegt und/oder über die Kommunikationsschnittstelle (4) übertragen werden, wobei weiterhin während des Messvorgangs der Spannung deren Frequenz ermittelt oder angenommen wird und je nach ermittelter oder angenommener Frequenz eine vorbestimmte Detektionsschwellen gesetzt und/oder angewandt wird.

14. Verfahren nach Anspruch 13, bei welchem über eine Applikationssoftware eines externen Empfängers (E) über die Kommunikationsschnittstelle zwischen einem ersten und einem zweiten Spannungsnennbereich des Messvorgangs umgeschaltet wird, wobei die vorbestimmte Detektionsschwelle dem jeweiligen Spannungsnennbereich zugehört.

15. Verfahren nach Anspruch 13 oder 14, bei welchem je nach Spannungsnennbereich eine Standardfrequenz angenommen wird und die vorbestimmte Detektionsschwelle zu dieser Standardfrequenz gesetzt wird, oderbei welchem eine vorbestimmte Frequenz angenommen wird und die vorbestimmte Detektionsschwelle zu dieser vorbestimmten Frequenz gesetzt wird, wobei während des Messvorgangs weiterhin die Frequenz überprüft und mit der vorbestimmten Frequenz verglichen wird und bei Abweichung eine Fehlermeldung ausgegeben wird, oder bei welchem die Frequenz gleichzeitig mit dem Messvorgang gemessen wird und die vorbestimmte Detektionsschwelle zu dieser gemessenen Frequenz gesetzt wird und nach einer erkannten Spannung oberhalb der vorbestimmten Detektionsschwelle die Frequenz erneut gemessen und überprüft wird und bei Abweichung eine Fehlermeldung ausgegeben wird, wobei die Frequenzmessung innerhalb einer vorbestimmten Zeit erfolgt um eine erfolgreiche Frequenzmessung zu erhalten, ansonsten wird die vorbestimmte Detektionsschwelle auf eine vorbestimmte kritische Detektionsschwelle gesetzt, oder, bei welchem die Frequenz gleichzeitig mit dem Messvorgang gemessen wird und wenn die Frequenz außerhalb von erwarteten Frequenzwerten liegt, wird ein jeweiliger Standardwert für die vorbestimmte Detektionsschwelle gesetzt, je nachdem ob die Frequenz größer oder kleiner der erwarteten Frequenzwerte ist, ansonsten werden jeweilige vorbestimmte Detektionsschwellen gesetzt, die den jeweiligen gemessenen Frequenzen zugehören, wobei die Frequenzmessung innerhalb einer vorbestimmten Zeit erfolgt um eine erfolgreiche Frequenzmessung zu erhalten, ansonsten wird die vorbestimmte Detektionsschwelle auf eine vorbestimmte kritische Detektionsschwelle gesetzt.

Fig. 1

S1 ⇨ S2 ⇨ S3 ⇨ S4

# Fig. 2

```
┌─────────────────┐
│  Detektions-    │
│ schwellen setzen│
└────────┬────────┘
         │
         ▼
     ╱─────────╲                        nein
    ╱ Nennspannungs-╲─────────────────────────────────┐
    ╲ bereich == 1? ╱                                  │
     ╲─────────╱                                       │
         │ ja                                          │
         ▼                                             ▼
     ╱────────╲   ja   ┌────────────────┐      ╱────────╲   ja   ┌────────────────┐
    ╱ Frequenz,╲──────▶│ Schwelle=Schwelle│    ╱ Frequenz,╲──────▶│ Schwelle=Schwelle│
    ╲ Nenn1 ==16?╱     │  16Hz, Nenn1   │    ╲ Nenn2 ==16?╱      │  16Hz, Nenn2   │
     ╲────────╱        └────────────────┘     ╲────────╱         └────────────────┘
         │                                        │
         ▼                                        ▼
     ╱────────╲   ja   ┌────────────────┐      ╱────────╲   ja   ┌────────────────┐
    ╱ Frequenz,╲──────▶│ Schwelle=Schwelle│    ╱ Frequenz,╲──────▶│ Schwelle=Schwelle│
    ╲ Nenn1 ==50?╱     │  50Hz, Nenn1   │    ╲ Nenn2 ==50?╱      │  50Hz, Nenn2   │
     ╲────────╱        └────────────────┘     ╲────────╱         └────────────────┘
         │                                        │
         ▼                                        ▼
     ╱────────╲   ja   ┌────────────────┐      ╱────────╲   ja   ┌────────────────┐
    ╱ Frequenz,╲──────▶│ Schwelle=Schwelle│    ╱ Frequenz,╲──────▶│ Schwelle=Schwelle│
    ╲ Nenn1 ==60?╱     │  60Hz, Nenn1   │    ╲ Nenn2 ==60?╱      │  60Hz, Nenn2   │
     ╲────────╱        └────────────────┘     ╲────────╱         └────────────────┘
```

# Fig. 3

```
┌──────────────────────┐
│     VARIANTE 1:      │
│ Prüfer mit festgelegter│
│      Frequenz        │
└──────────┬───────────┘
           │
           ▼
┌──────────────────────┐
│    Schwelle von      │
│    festgelegter      │
│  Frequenz setzen     │
└──────────┬───────────┘
           │
           ▼
┌──────────────────────┐◀─────────────────────┐
│   Spannungswert      │                       │
│     abtasten         │                       │
└──────────┬───────────┘                       │
           │                                   │
           ▼                                   │
       ╱────────╲                              │
      ╱ Spannungswert>=╲        nein           │
      ╲  Schwelle      ╱──────────────┐        │
       ╲────────╱                     │        │
           │ ja                       │        │
           ▼                          ▼        │
┌──────────────────┐      ┌──────────────────┐ │
│    ANZEIGE       │      │    ANZEIGE       │ │
│    Spannung      │      │  Spannungsfrei   │ │
│    vorhanden     │      │                  │ │
└────────┬─────────┘      └────────┬─────────┘ │
         │                         │           │
         └─────────────────────────┴───────────┘
```

# Fig. 4

VARIANTE 3:
Prüfer mit Kombi aus zwei
Frequenzen(z.b.50/60) und
Fehlermeldung bei
Frequenzabweichung

Spannungswert
abtasten

Frequenz
messen

Gemessen Frequenz ==50,60
oder 16 Hz? oder länger als
200ms keine Frequenz

ja

nein

Schwelle mit
gemessener
Frequenz setzen

Schwelle mit
kritischstem Wert
(50Hz/60Hz) setzen

Spannungswert>=
Schwelle

ja

nein

Gemessene Frequenz
== festgelegte Frequenz

Ja 50 oder 60

Nein, zB 16 Hz

ANZEIGE
Spannung vorhanden
(Buzzer & LEDs normale
Geschwindigkeit)

ANZEIGE
Spannung vorhanden
(Buzzer & LEDs normale
Geschwindigkeit)

ANZEIGE
Spannungsfrei

Fehlemeldung
über die App

Fig. 5

VARIANTE 4:
automatische
Frequenzerkennung

Spannungswert
abtasten

Frequenz
messen

Gemessen Frequenz ==50,60
oder 16 Hz? oder länger als
200ms keine Frequenz

ja

nein

Schwelle mit
gemessener
Frequenz setzen

Schwelle mit
Standardwerten
setzen

Spannungswert>=
Schwelle

ja

nein

ANZEIGE
Spannung
vorhanden

ANZEIGE
Spannungsfrei

Fig. 6

Antasterkennung im
Spannungsprüfer

bei freigeschaltener
Anlage

bei Anlage
unter Spannung

Spannung
prüfen

nein

Spannung
prüfen

nein

Antasterkennung
über Beschl.Sensor

Elektrische
Restspannungsimpulserkennung

Antasterkennung
über Beschl.Sensor

Spannungsdetektion

&

ja

&

ja

Erfolgreich angetastet
Spannungsfrei

Erfolgreich angetastet
Spannung vorhanden

# Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012110623 B4